(19) Europäisches Patentamt
European Patent Office
Office européen des brevets

(11) **EP 4 716 102 A1**

(12) **EUROPEAN PATENT APPLICATION**

(43) Date of publication:
**25.03.2026  Bulletin 2026/13**

(21) Application number: **25203874.0**

(22) Date of filing: **23.09.2025**

(51) International Patent Classification (IPC):
**H04B 1/525** $^{(2015.01)}$

(52) Cooperative Patent Classification (CPC):
**H04B 1/525**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **23.09.2024  KR 20240128509**

(71) Applicant: **Samsung Electronics Co., Ltd.**
**Suwon-si, Gyeonggi-do 16677 (KR)**

(72) Inventors:
• **KIM, Daeyoung**
**16677 Gyeonggi-do (KR)**
• **YU, Hyunseok**
**16677 Gyeonggi-do (KR)**

(74) Representative: **Marks & Clerk LLP**
**15 Fetter Lane**
**London EC4A 1BW (GB)**

(54) **INTERFERENCE CANCELLATION CIRCUIT AND OPERATING METHOD THEREOF**

(57)    A multiple interference cancellation circuit includes a first kernel generation circuit that receives transmission signals and, based on the transmission signals, generates a first interference model signal, a second kernel generation circuit that receives the transmission signals and, based on the plurality of transmission signals, generates a second interference model signal different from the first interference model signal, a first adaptive filter that receives the first interference model signal and, based on the first interference model signal and a first filter coefficient, generates a first interference estimation signal, a second adaptive filter that receives the second interference model signal and, based on the second interference model signal and a second filter coefficient, generates a second interference estimation signal, and a first summer that outputs a filtering signal obtained by subtracting the first interference estimation signal and the second interference estimation signal from a reception signal.

FIG. 5

**Description**

BACKGROUND

The present disclosure relates to an interference cancellation circuit and an operating method thereof, and more particularly, to an interference cancellation circuit for cancelling intermodulation interference based on a combination of transmission signals, and an operating method of the interference cancellation circuit.

A wireless communication system may employ various techniques to increase throughput. For example, a wireless communication system may employ carrier aggregation (CA), Evolved Universal Mobile Telecommunications System (UMTS) Terrestrial Radio Access-New Radio (E-UTRA-NR) network dual connectivity (EN-DC), multiple-input and multiple-output (MIMO), and the like, which increase communication capacity.

In some cases, an interference signal may be generated by a transmission signal leaked to a reception path or coupled onto the reception path within a terminal. When a plurality of transmission signals are independently transmitted according to transmission techniques such as CA, EN-DC, and MIMO, transmission frequencies of the plurality of transmission signals may be different from each other, and interference due to intermodulation between the transmission signals of different frequencies may occur.

SUMMARY

According to an aspect of one or more embodiments, there is provided a multiple interference cancellation circuit that includes a first kernel generation circuit configured to receive a plurality of transmission signals and, based on the plurality of transmission signals, generate a first interference model signal, a second kernel generation circuit configured to receive the plurality of transmission signals and, based on the plurality of transmission signals, generate a second interference model signal different from the first interference model signal, a first adaptive filter configured to receive the first interference model signal from the first kernel generation circuit and, based on the first interference model signal and a first filter coefficient, generate a first interference estimation signal, a second adaptive filter configured to receive the second interference model signal from the second kernel generation circuit and, based on the second interference model signal and a second filter coefficient, generate a second interference estimation signal, and a first summer configured to output a filtering signal obtained by subtracting the first interference estimation signal and the second interference estimation signal from a reception signal.

According to another aspect of one or more embodiments, there is provided an operating method of a multiple interference cancellation circuit, the operating method comprising in a first kernel generation circuit, receiving a plurality of transmission signals and, based on the plurality of transmission signals, generating a first interference model signal; in a second kernel generation circuit, receiving the plurality of transmission signals and, based on the plurality of transmission signals, generating a second interference model signal different from the first interference model signal; in a first adaptive filter, receiving the first interference model signal from the first kernel generation circuit and generating a first interference estimation signal based on the first interference model signal and a first filter coefficient; in a second adaptive filter, receiving the second interference model signal from the second kernel generation circuit and generating a second interference estimation signal based on the second interference model signal and a second filter coefficient; and outputting a filtering signal obtained by subtracting the first interference estimation signal and the second interference estimation signal from a reception signal.

According to yet another aspect of one or more embodiments, there is provided a multiple interference cancellation circuit that includes a plurality of kernel generation circuits configured to receive a plurality of transmission signals and, based on the plurality of transmission signals, generate a plurality of interference model signals, a plurality of adaptive filters configured to receive the plurality of interference model signals and, based on the plurality of interference model signals and a plurality of filter coefficients, generate a plurality of interference estimation signals, and a summer configured to output a filtering signal obtained by subtracting the plurality of interference estimation signals from a reception signal, wherein the plurality of adaptive filters operate in parallel.

At least some of the above and other features of the invention are set out in the claims.

BRIEF DESCRIPTION OF THE DRAWINGS

Various embodiments will be more clearly understood from the following detailed description taken in conjunction with the accompanying drawings, in which:

FIG. 1 is a diagram illustrating an example of self-interference, according to an embodiment;
FIG. 2 is a circuit diagram of a circuit including an interference cancellation circuit, according to a comparative example;

FIG. 3 is a diagram illustrating a multiple interference cancellation circuit, according to an embodiment;

FIG. 4 is a flowchart illustrating an operating method of a multiple interference cancellation circuit, according to an embodiment;

FIG. 5 is a diagram illustrating an example of a multiple interference cancellation circuit, according to an embodiment;

FIG. 6 is a diagram illustrating an example of a multiple interference cancellation circuit, according to an embodiment;

FIG. 7 is a diagram illustrating an example of occurrence of a pre-cancellation error, according to an embodiment;

FIG. 8 is a diagram illustrating an example of a multiple interference cancellation circuit, according to an embodiment;

FIG. 9A is a diagram illustrating an example of a multiple interference cancellation circuit, according to an embodiment;

FIG. 9B is a diagram illustrating an example of a multiple interference cancellation circuit, according to an embodiment;

FIG. 10 is a diagram illustrating an example of a multiple interference cancellation circuit, according to an embodiment;

FIG. 11 is a diagram illustrating an example of a multiple interference cancellation circuit, according to an embodiment;

FIG. 12 is a diagram illustrating an example of a multiple interference cancellation circuit, according to an embodiment;

FIG. 13 is a diagram illustrating an example of a multiple interference cancellation circuit, according to an embodiment; and

FIG. 14 is a block diagram illustrating a wireless communication device, according to an embodiment.

## DETAILED DESCRIPTION

As described above, a wireless communication system may employ various techniques to increase throughput, and for example, may employ carrier aggregation (CA), E-UTRA(Evolved-Universal Terrestrial Radio Access)-NR(New Radio) network dual connectivity (EN-DC), multiple-input and multiple-output (MIMO), and the like. These various techniques increase communication capacity by using a plurality of antennas. With the adoption of techniques for increasing throughput, transmitting sides may transmit signals with high complexity and receiving sides may be required to process the signals with high complexity.

An interference signal may hinder a receiving side from processing a signal received through an antenna, and the interference signal may be generated in various ways. For example, the interference signal may include inter-cell interference, which is a signal received from a neighboring base station at a boundary of a serving base station, intra-cell interference, which corresponds to a radio signal from another terminal within coverage of a serving base station, channel interference, and the like.

In addition to the interference signal received through the antenna, as discussed above, there is also the interference signal generated by the transmission signal leaked to the reception path or coupled onto the reception path within a terminal. In the case of a self-interference signal generated within the terminal, the power-amplified transmission signal is fed back as an interference signal as it is, which may have a great impact on the deterioration of reception sensitivity. In this case, when a plurality of transmission signals are independently transmitted according to transmission techniques such as CA, EN-DC, and MIMO, transmission frequencies of the plurality of transmission signals may be different from each other, and interference due to intermodulation between the transmission signals of different frequencies may additionally occur. Therefore, there is a need for a method of cancelling interference caused by intermodulation.

Hereinafter, various embodiments will be described with reference to the accompanying drawings. As used in this specification, a phrase using the form "at least one of A, B, or C" includes within its scope "only A", "only B", "only C", "A and B", "A and C", "B and C" and "A, B, and C."

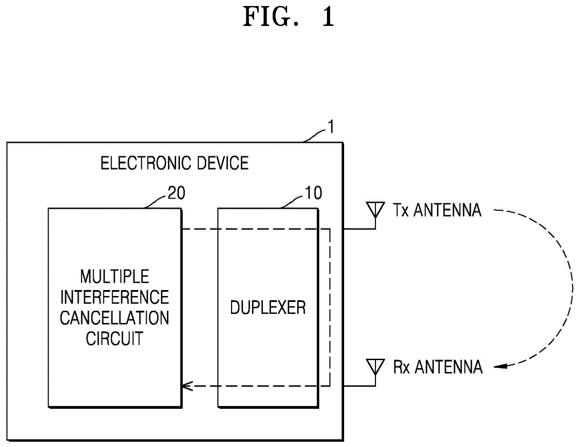

FIG. 1 is a diagram illustrating an example of self-interference, according to an embodiment.

Referring to FIG. 1, an electronic device 1 may include a duplexer 10 and a multiple interference cancellation circuit 20. The electronic device 1 may correspond to a user equipment (UE).

According to an embodiment, the duplexer 10 may perform signal transmission/reception through a transmission (Tx) antenna and a reception (Rx) antenna. The duplexer 10 may be connected to the transmission antenna and the reception antenna. For example, the transmission antenna and the reception antenna may be respectively connected to a transmission radio frequency (RF) chain and a reception RF chain through the duplexer. The duplexer 10 may receive a wireless signal through the reception RF chain, and may transmit a baseband signal to an external device through the transmission RF chain.

According to some embodiments, in the case of the electronic device 1 including the transmission (Tx) antenna and the reception (Rx) antenna connected through the duplexer 10, feedback of a transmission signal based on the transmission antenna and the reception antenna adjacent to each other may occur. Because the duplexer 10 is connected to both the transmission RF chain and the reception RF chain, at least a part of a transmission signal from the transmission RF chain may be leaked to the reception RF chain. When the leaked signal is input to the reception RF chain, interference may occur. When signals are leaked from two or more transmission RF chains to the reception RF chain, intermodulation may occur between the signals leaked through the two or more transmission RF chains, and thus, interference due to the intermodulation (hereinafter, intermodulation interference) may occur. Multiple interference may include both the self-interference and the intermodulation interference.

The multiple interference cancellation circuit 20 may cancel the multiple interference. For example, the multiple interference cancellation circuit 20 may include an adaptive filter configured to change a coefficient to converge the filter to an optimal state. The multiple interference cancellation circuit 20 may cancel multiple self-interference by updating a filter coefficient so that an error, which is a difference between a reception signal and an interference estimation signal, converges to 0. The multiple interference cancellation circuit 20 will be described below in detail.

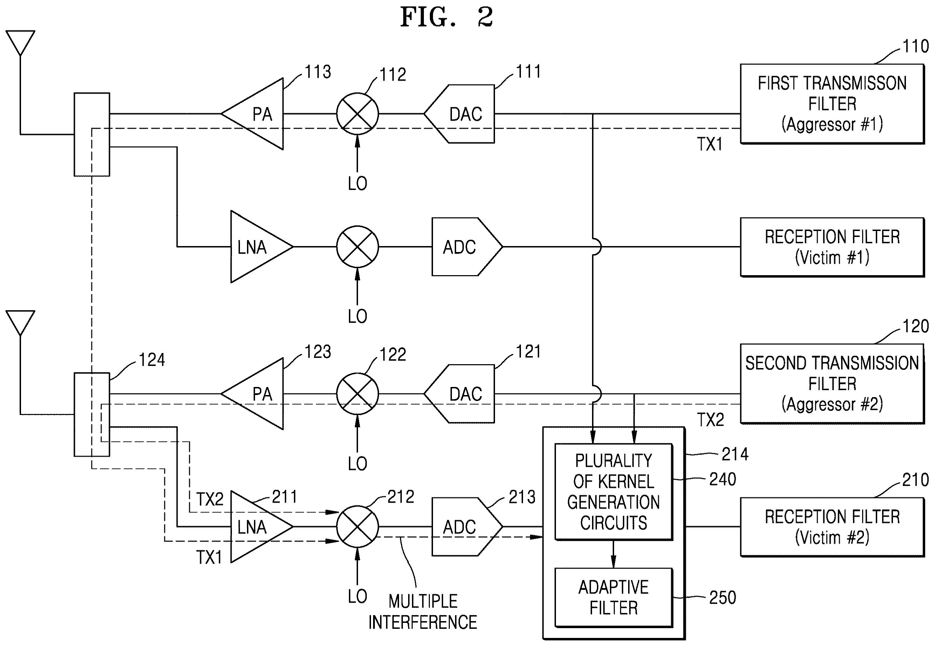

FIG. 2 is a circuit diagram of a circuit including an interference cancellation circuit 214 according to a comparative example.

Referring to FIG. 2, a first transmission signal TX1 and a second transmission signal TX2 may be transmitted. For example, only a desired frequency band may be filtered from the first transmission signal TX1 through a first transmission filter (e.g., Aggressor #1) 110, and the first transmission signal TX1 may be converted from a digital signal into an analog signal through a first digital-to-analog converter (DAC) 111. A transmission frequency of the first transmission signal TX1 may be up-converted by a local oscillator (LO) frequency received from an LO through a first mixer 112, may be amplified through a first power amplifier (PA) 113, and then may be transmitted to an external device (e.g., a base station) through an antenna.

Only a desired frequency band is filtered from the second transmission signal TX2 through a second transmission filter (e.g., Aggressor #2) 120, and the second transmission signal TX2 may be converted from a digital signal into an analog signal through a second DAC 121. A transmission frequency of the second transmission signal TX2 may be up-converted by an LO frequency received by a second mixer 122, may be amplified through a second PA 123, and then may be transmitted to the external device through an antenna.

According to various embodiments, the electronic device 1 may perform carrier aggregation or dual connectivity, and all of the first transmission filter 110, the second transmission filter 120, and a reception filter (e.g., Victim#2) 210 may be in an on state. In this case, when self-interference occurs, the first transmission signal TX1 amplified through the first PA 113 may be coupled onto a neighboring reception RF chain. For example, the first transmission signal TX1 may be input as a reception signal to a low noise amplifier (LNA) 211 of the reception RF chain (see dashed line in FIG. 2). The second transmission signal TX2 may leak from a transmission RF chain connected through a duplexer 124. That is, the second transmission signal TX2 may be input as a reception signal to the LNA 211 through the duplexer 124 (see dashed line in FIG. 2). The first transmission signal TX1 and the second transmission signal TX2 may generate an interference signal near a reception frequency due to nonlinear characteristics of the reception RF chain, which may be down-converted by an LO frequency received by a third mixer 212, and may be converted into a digital signal through an analog-to-digital converter (ADC) 213. Thereafter, the interference signal generated by the first transmission signal TX1 and the second transmission signal TX2 may be cancelled through the interference cancellation circuit 214 according to the comparative example. In an embodiment, similar to the reception RF chain corresponding to the transmission RF chain including the second transmission filter 120, the reception RF chain corresponding to the transmission RF chain including the first transmission filter 110 may include a reception filter (e.g., Victim #1).

The interference cancellation circuit 214 according to the comparative example may include a plurality of kernel generation circuits 240 and an adaptive filter 250. The plurality of kernel generation circuits 240 may be circuits configured to receive the interference signal (e.g., the first transmission signal TX1 and the second transmission signal TX2) and reproduce (or regenerate) an interference model. The adaptive filter 250 may generate a plurality of interference estimation signals by estimating coefficients of the plurality of kernel generation circuits 240, and may perform filtering by subtracting the plurality of interference estimation signals from a reception signal. For example, the adaptive filter 250 may perform filtering based on a recursive least square (RLS) algorithm. According to the comparative example, in addition to the nonlinear characteristics of the reception RF chain, interference due to intermodulation between signals leaked through two or more transmission RF chains may also occur.

According to the comparative example, the interference cancellation circuit 214 may cancel interference by using one adaptive filter 250. However, in order for one adaptive filter 250 to cancel all interference, the number of filter taps should be increased for each of the plurality of interference estimation signals, which may greatly increase complexity.

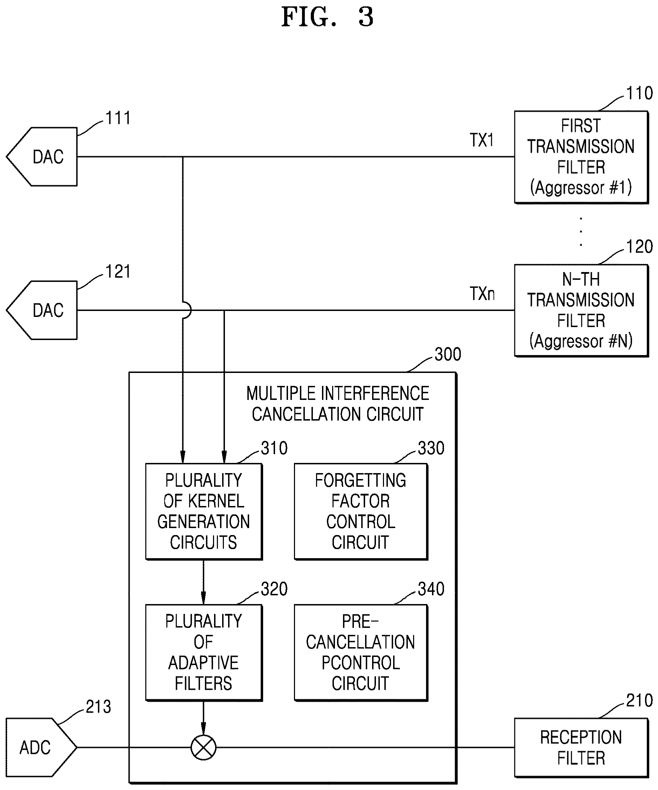

FIG. 3 is a diagram illustrating a multiple interference cancellation circuit 300, according to an embodiment.

Referring to FIG. 3, the multiple interference cancellation circuit 300 may include a plurality of kernel generation circuits 310, a plurality of adaptive filters 320, a forgetting factor control circuit 330, and a pre-cancellation control circuit 340. The first transmission filter 110, an N-th transmission filter (e.g., Aggressor #N) 120, the first DAC 111, the second DAC 121, the reception filter 210, and the ADC 213 have a same configuration and function as described above with reference to FIG. 2, and thus the same description as that made for the first transmission filter 110, the second transmission filter 120, the first DAC 111, the second DAC 121, the reception filter 210, and the ADC 213 with reference to FIG. 2 will be omitted for conciseness.

According to an embodiment, the plurality of kernel generation circuits 310 may be circuits configured to receive a plurality of transmission signals and reproduce (or regenerate) an interference model. The reproduced interference model may include both an active interference signal and a passive interference signal. According to an embodiment, the number of the plurality of kernel generation circuits 310 may be independent of the number of transmission RF chains. For example, the number of transmission RF chains may be M (M is a natural number greater than 0), and the number of the plurality of kernel generation circuits 310 may be N (N is a natural number greater than 0).

Hereinafter, for convenience of explanation, it is assumed that each of the number of transmission RF chains and the number of the plurality of kernel generation circuits 310 is N. The plurality of transmission signals may be transmission signals of the plurality of transmission RF chains. The plurality of kernel generation circuits 310 may receive the plurality of transmission signals and generate a plurality of interference model signals. For example, a first kernel generation circuit may receive all transmission signals of a first transmission RF chain to an $N^{th}$ transmission RF chain and may generate a first interference model signal based on the transmission signals. An $N^{th}$ kernel generation circuit may receive all transmission signals of the first transmission RF chain to the $N^{th}$ transmission chain and may generate an $N^{th}$ interference model signal.

According to an embodiment, the plurality of adaptive filters 320 may generate an interference signal by estimating coefficients of the plurality of kernel generation circuits 310, and may perform filtering on the interference signal by subtracting the interference signal from a reception signal. In an embodiment, the number of the plurality of adaptive filters 320 may be the same as the number of the plurality of kernel generation circuits 310. In detail, in some embodiments, the plurality of adaptive filters 320 may be mapped to the plurality of kernel generation circuits 310 in a one-to-one manner. For example, a first adaptive filter may estimate a coefficient of the first kernel generation circuit corresponding to the first transmission RF chain, and an $N^{th}$ adaptive filter may estimate a coefficient of the $N^{th}$ kernel generation circuit corresponding to the $N^{th}$ transmission RF chain. According to an embodiment, each of the plurality of adaptive filters 320 may be based on an adaptive filter algorithm. For example, each of the plurality of adaptive filters 320 may be based on at least one of a recursive least squares (RLS) algorithm, a least mean square (LMS) algorithm using a stochastic gradient descent method, or a dichotomous coordinate descent (DCD)-RLS algorithm.

According to an embodiment, the forgetting factor control circuit 330 may calculate an integrated forgetting factor. The integrated forgetting factor may refer to a forgetting factor commonly applied to the plurality of adaptive filters 320. The forgetting factor control circuit 330 may be activated or deactivated according to an operation mode. For example, the electronic device 1 may determine to operate in a first operation mode. The first operation mode may be an operation mode in which an integrated forgetting factor is calculated by considering not only an interference estimation error based on a transmission signal but also a pre-cancellation error caused by pre-cancelling interference estimation signals of other adaptive filters. In the first operation mode, the forgetting factor control circuit 330 may calculate a forgetting factor based on an interference estimation error and a pre-cancellation error, and the calculated forgetting factor may be commonly applied to the plurality of adaptive filters 320.

When the electronic device 1 does not operate in the first operation mode, the forgetting factor control circuit 330 may be deactivated. According to the comparative example, when the electronic device 1 is not in the first operation mode, each of the plurality of adaptive filters 320 may perform filter updating based on its own forgetting factor.

The pre-cancellation control circuit 340 may activate or deactivate at least one interference estimation signal based on a mask signal. The mask signal may be a signal generated by a valid mask circuit (otherwise known as a "mask circuit"). The mask signal may be a signal indicating which transmission RF chain is in a deactivated or activated state. According to an embodiment, the pre-cancellation control circuit 340 may be activated or deactivated according to an operation mode. For example, the electronic device 1 may determine to operate in a second operation mode. The second operation mode may be an operation mode for controlling whether to cancel each interference during pre-cancellation using the mask signal.

For example, when the first transmission RF chain is deactivated, a first transmission signal of the first transmission RF chain may disappear. When the first transmission signal disappears, interference due to intermodulation of the first transmission signal and at least one other transmission signal may also disappear. Accordingly, generating an interference pre-cancellation signal on the assumption that the first transmission signal exists may cause an unexpected error when interference is cancelled by using a channel coefficient of a previous sample even though interference to be pre-cancelled has disappeared. The pre-cancellation control circuit 340 may deactivate a first interference estimation signal corresponding to the first transmission signal, based on a mask signal indicating that the first transmission signal has been deactivated. When the first interference estimation signal is deactivated, a component of the first interference estimation signal may disappear from each of interference pre-cancellation signals input to the plurality of adaptive filters 320, thereby preventing an unexpected error.

In another example, when the first transmission RF chain is activated, the first transmission signal of the first transmission RF chain may suddenly appear. Interference due to intermodulation of the first transmission signal and at least one other transmission signal may suddenly occur. Accordingly, when a channel coefficient of a previous sample is used even though the first transmission signal suddenly appears, an unexpected error may be caused. The pre-cancellation control circuit 340 may activate the first interference estimation signal corresponding to the first transmission signal, based on a mask signal indicating that the first transmission signal has been activated. When the first interference estimation signal is activated, a component of the first interference estimation signal may be added to each of the interference pre-cancellation signals input to the plurality of adaptive filters 320, thereby preventing an unexpected error.

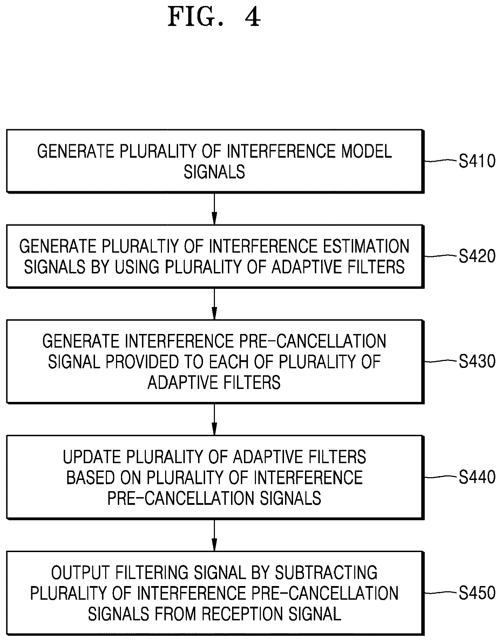

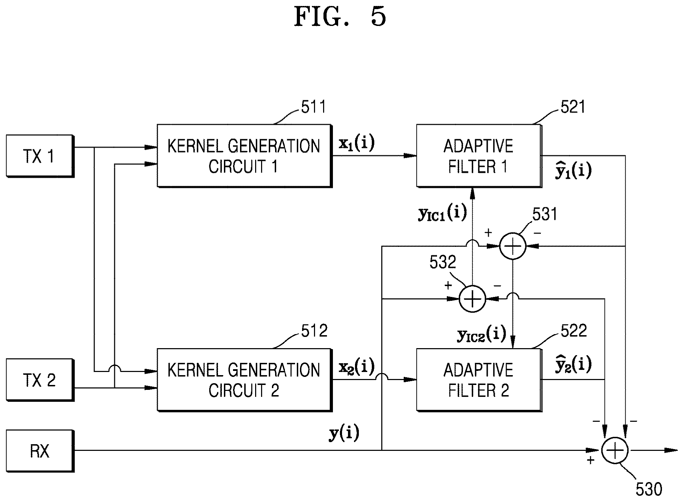

FIG. 4 is a flowchart illustrating an operating method of a multiple interference cancellation circuit, according to an embodiment. FIG. 5 is a diagram illustrating an example of a multiple interference cancellation circuit, according to an embodiment.

Referring to FIG. 4, in operation S410, a multiple interference cancellation circuit (e.g., the multiple interference cancellation circuit 300 of FIG. 3) may generate a plurality of interference model signals. Each of a plurality of kernel generation circuits (e.g., the plurality of kernel generation circuits 310 of FIG. 3) may generate an interference model signal based on a plurality of transmission signals. For example, a first kernel generation circuit may receive a first transmission signal of a first transmission RF chain to an $N^{th}$ transmission signal of an $N^{th}$ transmission RF chain. The first kernel generation circuit may generate a first interference model signal based on the first transmission signal to the $N^{th}$ transmission signal.

Referring to FIG. 5 together with FIG. 4, for convenience of explanation, it is assumed that the number of a plurality of RF transmission chains is 2. The first kernel generation circuit may correspond to a kernel generation circuit 1 511 of FIG. 5, and a second kernel generation circuit may correspond to a kernel generation circuit 2 512 of FIG. 5. A first transmission signal may correspond to TX 1, and a second transmission signal may correspond to TX 2.

The kernel generation circuit 1 151 may receive TX 1 and TX 2 and may generate a first interference model signal. The first interference model signal may be $\mathbf{x}_1(i)$. The kernel generation circuit 2 512 may receive TX 1 and TX 2 and may generate a second interference model signal. The second interference model signal may be $\mathbf{x}_2(i)$.

In operation S420, the multiple interference cancellation circuit 300 may generate a plurality of interference estimation signals by using a plurality of adaptive filters, respectively. To this end, each of the plurality of adaptive filters (e.g., the plurality of adaptive filters 320 of FIG. 3) may receive an interference model signal. Each of the plurality of adaptive filters 320 may generate an interference estimation signal based on the received interference model signal. In an embodiment, each of the plurality of adaptive filters 320 may generate an interference estimation signal based on the received interference model signal and a corresponding filter coefficient.

Referring to FIG. 5 together with FIG. 4, a first adaptive filter may correspond to an adaptive filter 1 521 of FIG. 5, and a second adaptive filter may correspond to an adaptive filter 2 522 of FIG. 5. The first adaptive filter 1 521 may receive the first interference model signal $\mathbf{x}_1(i)$ from the corresponding kernel generation circuit 1 511 and may generate a first interference estimation signal $\hat{y}_1(i)$. The adaptive filter 2 522 may receive the second interference model signal $\mathbf{x}_2(i)$ from the corresponding kernel generation circuit 2 512 and may generate a second interference estimation signal $\hat{y}_2(i)$. In some embodiments, the first interference estimation signal $\hat{y}_1(i)$ may be generated based on the first interference model signal $\mathbf{x}_1(i)$ and a first filter coefficient. In some embodiments, the second interference estimation signal $\hat{y}_2(i)$ may be generated based on the second interference model signal $\mathbf{x}_2(i)$ and a second filter coefficient. For example, the first interference estimation signal $\hat{y}_1(i)$ and the second interference estimation signal $\hat{y}_2(i)$ may be as shown in the following equations.

[Equation 1]

$$\hat{y}_1(i) = \hat{\mathbf{h}}_1^H(i-1)\mathbf{x}_1(i)$$

[Equation 2]

$$\hat{y}_2(i) = \hat{\mathbf{h}}_2^H(i-1)\mathbf{x}_2(i)$$

Here, $\hat{\mathbf{h}}_1^H$ may correspond a first channel coefficient for multiple interference, $\hat{\mathbf{h}}_2^H$ may correspond to a second channel coefficient for multiple interference, and $i$ is a sample index. In an embodiment, a channel coefficient may correspond to a conjugate transpose of a filter coefficient. In the present specification, unless otherwise stated, superscript H may represent the Hermitian transpose, otherwise known as the conjugate transpose (for instance, $\hat{\mathbf{h}}_1^H$ may be the Hermitian transpose of the first filter coefficient $\hat{\mathbf{h}}_1$). According to an embodiment, an interference estimation signal may be based on a channel coefficient of a previous sample. For example, the first interference estimation signal $\hat{y}_1(i)$ may be obtained by multiplying the first channel coefficient $\hat{\mathbf{h}}_1^H(i-1)$ (e.g. the Hermitian transpose of the first filter coefficient) calculated in an $(i-1)^{th}$ sample by the first interference model signal $\mathbf{x}_1(i)$ calculated in an $i^{th}$ sample. The second

interference estimation signal $\hat{y}_2(i)$ may be obtained by multiplying the second channel coefficient $\hat{\mathbf{h}}_2^H(i-1)$ (e.g. the Hermitian transpose of the first filter coefficient) calculated in the (i-1)$^{th}$ sample by the second interference model signal $\mathbf{x}_2$ ($i$) calculated in the i$^{th}$ sample.

In operation S430, the multiple interference cancellation circuit 300 may generate an interference pre-cancellation signal provided to each of the plurality of adaptive filters 320. The interference pre-cancellation signal is a signal in which interference signals estimated by other adaptive filters are pre-cancelled for parallel interference cancellation (PIC).

Referring to FIG. 5 together with FIG. 4, the adaptive filter 1 521 may receive a first interference pre-cancellation signal $y_{IC1}(i)$. The first interference pre-cancellation signal $y_{IC1}(i)$ may be used to update a filter coefficient of the adaptive filter 1 521. The first interference pre-cancellation signal $y_{IC1}(i)$ may be calculated according to the following equation.

[Equation 3]

$$y_{IC1}(i) = y(i) - \hat{\mathbf{h}}_2^H(i-1)\mathbf{x}_2(i)$$

Here, $y(i)$ is a reception signal. The first interference pre-cancellation signal $y_{IC1}(i)$ is a signal obtained by subtracting the second interference estimation signal $\hat{y}_2(i)$ corresponding to an output of the adaptive filter 2 522, which is the remaining adaptive filter, from the reception signal y(i). To this end, the multiple interference cancellation circuit 300 may further include a summer 532 (otherwise known as an adder). The summer 532 may generate a first interference pre-cancellation signal $y_{IC1}(i)$ by inverting a sign of the second interference estimation signal $\hat{y}_2(i)$ received from the adaptive filter 2 522 and adding the result to the reception signal $y(i)$. The summer 532 may generate the first interference pre-cancellation signal $y_{IC1}(i)$ by subtracting the second interference estimation signal $\hat{y}_2(i)$ from the reception signal y(i). The summer 532 may achieve this may adding the negative of the second interference estimation signal $\hat{y}_2(i)$ to the reception signal $y(i)$. The negative of the second interference estimation signal $\hat{y}_2(i)$ may be obtained by determining the two's complement of the second interference estimation signal $\hat{y}_2(i)$ (e.g. by inverting the second interference estimation signal $\hat{y}_2(i)$ and adding one to the result). The summer 532 may output the first interference pre-cancellation signal $y_{IC1}(i)$ to the adaptive filter 1 521. According to the comparative example, in the case of the interference cancellation circuit 214 not based on joint estimation or PIC of FIG. 2, because a channel of a previous sample is not used, the first interference pre-cancellation signal may be as shown in the following equation.

[Equation 4]

$$y_{IC1}(i) = y(i) - \hat{\mathbf{h}}_2^H(i-1)\mathbf{x}_2(i)$$

According to an embodiment, when there is no change in an interference channel, performance based on joint estimation and performance based on a PIC method may be the same.

Likewise, a second interference pre-cancellation signal $y_{IC2}(i)$ may be as follows.

[Equation 5]

$$y_{IC2}(i) = y(i) - \hat{\mathbf{h}}_1^H(i-1)\mathbf{x}_1(i)$$

Here, $y(i)$ is the reception signal. The second interference pre-cancellation signal $y_{IC2}(i)$ is a signal obtained by subtracting the first interference estimation signal $\hat{y}_1(i)$ corresponding to an output of the adaptive filter 1 521, which the remaining adaptive filter, from the reception signal. To this end, the multiple interference cancellation circuit 300 may further include a summer 531. The summer 531 may generate the second interference pre-cancellation signal $y_{IC2}(i)$ by inverting a sign of the first interference estimation signal $\hat{y}_1(i)$ received from the adaptive filter 1 521 and adding the result to the reception signal y(i). The summer 531 may generate the second interference pre-cancellation signal $y_{IC2}(i)$ by subtracting the first interference estimation signal $\hat{y}_1(i)$ from the reception signal $y(i)$ (e.g. in a similar manner to the summer 532). The summer 531 may output the second interference pre-cancellation signal $y_{IC2}(i)$ to the adaptive filter 2 522.

According to an embodiment, when generalized, an interference pre-cancellation signal input to an adaptive filter may be a signal obtained by subtracting interference estimation signals output from remaining adaptive filters except for an interference estimation signal output from the adaptive filter itself from a reception signal.

In operation S440, the multiple interference cancellation circuit 300 may update the plurality of adaptive filters based on a plurality of interference pre-cancellation signals. Each of the plurality of adaptive filters may have received an interference pre-cancellation signal in operation S430. For example, the adaptive filter 1 521 receives the first interference pre-cancellation signal $y_{IC1}(i)$ from the summer 532, and the adaptive filter 2 522 receives the second interference pre-

cancellation signal $y_{IC2}(i)$ from the summer 531. The adaptive filter 1 521 may update a filter coefficient based on the first interference pre-cancellation signal $y_{IC1}(i)$. In some embodiments, the adaptive filter 1 521 may update a filter coefficient $\hat{h}_1$ ($i$) of a current sample based on a filter coefficient $\hat{h}_1(i-1)$ of a previous sample, a gain vector $\mathbf{k}_1$ ($i$) of the current sample, and an error $e_1(i)$. For example, the updating of the filter coefficient $\hat{h}_1$ for the adaptive filter 1 521 may be based on the following equation.

[Equation 6]

$$\hat{h}_1(i) = \hat{\mathbf{h}}_1(i-1) + \mathbf{k}_1(i)e_1^*(i)$$

Here, $e_1^*(i)$ is a complex conjugate for an error of the adaptive filter 1 521 in the $i^{th}$ sample, and $\mathbf{k}_1(i)$ is a gain vector of the adaptive filter 1 521 in the $i^{th}$ sample. An error $e_1(i)$ of the adaptive filter 1 521 may be calculated according to the following equation.

[Equation 7]

$$e_1(i) = \underbrace{y(i) - \hat{\mathbf{h}}_2^H(i-1)\mathbf{x}_2(i)}_{y_{IC1}(i)} - \hat{\mathbf{h}}_1^H(i-1)\mathbf{x}_1(i)$$

Then error of the adaptive filter 1 521 is a value obtained by subtracting the first interference estimation signal $\hat{y}_1(i)$ from the first interference pre cancellation signal $y_{IC1}(i)$. Also, in some embodiments, the adaptive filter 1 521 may calculate a gain vector $\mathbf{k}_1(i)$ of a current sample based on a forgetting factor corresponding to the adaptive filter 1 521, the first interference model signal $\mathbf{x}_1(i)$, and an inverse matrix $\mathbf{P}_1(i-1)$ of a covariance matrix of a previous sample. For example, the gain vector $\mathbf{k}_1(i)$ of the adaptive filter 1 521 may be based on the following equation.

[Equation 8]

$$\mathbf{k}_1(i) = \frac{\mathbf{P}_1(i-1)\mathbf{x}_1(i)}{\lambda_1 + \mathbf{x}_1^H(i)\mathbf{P}_1(i-1)\mathbf{x}_1(i)}$$

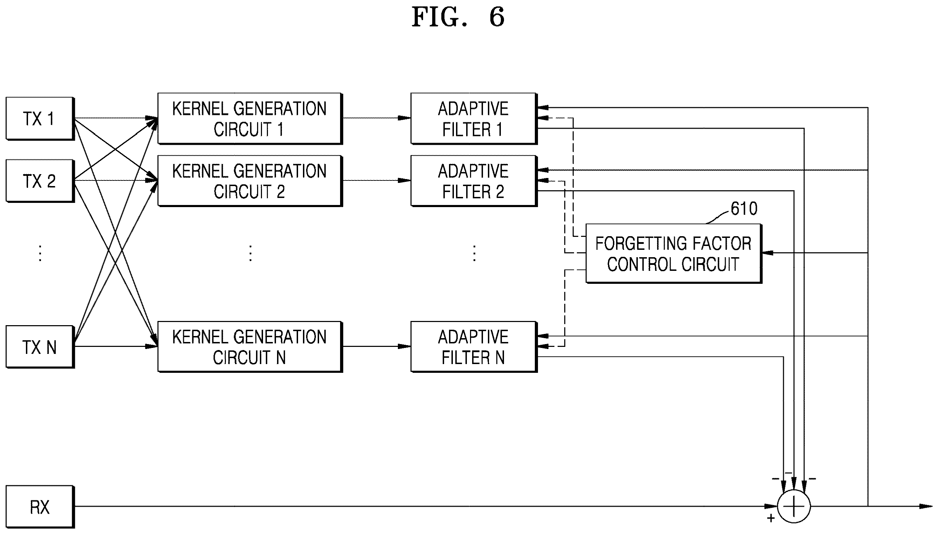

Here, $\lambda_1$ is a forgetting factor of the adaptive filter 1 521, $\mathbf{P}_1(i-1)$ is an inverse matrix of a covariance matrix in the $(i-1)^{th}$ sample, and $\mathbf{x}_1^H(i)$ is a Hermitian transpose of the first interference model signal $\mathbf{x}_1(i)$ for the $i^{th}$ sample. The forgetting factor $\lambda_1$ may be fixed (e.g. may be predefined). Alternatively, the forgetting factor $\lambda_1$ may be an integrated forgetting factor which is calculated (e.g. by the forgetting factor control circuit 610 of FIG. 6). In some embodiments, when the gain vector $\mathbf{k}_1(i)$ of the adaptive filter 1 521 is calculated, the adaptive filter 1 521 may calculate an inverse matrix $\mathbf{P}_1(i)$ of a covariance matrix of a current sample based on the forgetting factor corresponding to the adaptive filter 1 521, the first interference model signal $\mathbf{x}_1(i)$, and the inverse matrix $\mathbf{P}_1(i-1)$ of the covariance matrix of the previous sample. For example, an inverse matrix of a covariance matrix $\mathbf{P}_1(i)$ in the $i^{th}$ sample may be updated according to the following equation.

[Equation 9]

$$\mathbf{P}_1(i) = \frac{1}{\lambda_1}[\mathbf{P}_1(i-1) - \mathbf{k}_1(i)\mathbf{x}_1^H(i)\mathbf{P}_1(i-1)]$$

That is, the inverse matrix of the covariance matrix $\mathbf{P}_1(i)$ in the $i^{th}$ sample may be updated based on the gain vector $\mathbf{k}_1(i)$ of the adaptive filter 1 521, the forgetting factor $\lambda_1$ of the adaptive filter 1 521, the first interference model signal $\mathbf{x}_1(i)$, and the inverse matrix of the covariance matrix $\mathbf{P}_1(i-1)$ of the previous sample.

According to an embodiment, in a next sample (e.g., an $(i+1)^{th}$ sample), an error $e_1(i+1)$ of the adaptive filter 1 521 may be updated by repeatedly calculating Equations 6 to 9 described above. As calculation is repeatedly performed according to according to samples, an error of the adaptive filter 1 521 may be reduced, and thus, multiple interference may be cancelled.

According to an embodiment, the adaptive filter 2 522 may update a filter coefficient based on the second interference pre-cancellation signal $y_{IC2}(i)$. In some embodiments, the adaptive filter 2 522 may update a filter coefficient

$\hat{\mathbf{h}}_2$(i) of a current sample based on a filter coefficient $\hat{\mathbf{h}}_2$(*i* - 1) of a previous sample, a gain vector $\mathbf{k}_2$(i) of the current sample, and an error $e_2$(*i*). For example, the updating of the filter coefficient $\hat{\mathbf{h}}_2$ for the adaptive filter 2 522 may be based on the following equation.

[Equation 10]

$$\hat{\mathbf{h}}_2(i) = \hat{\mathbf{h}}_2(i-1) + \mathbf{k}_2(i)e_2^*(i)$$

Here, $e_2^*(i)$ is a complex conjugate for an error of the adaptive filter 2 522 in the ith sample, and $\mathbf{k}_2$(i) is a gain vector of the adaptive filter 2 522 in the ith sample. An error $e_2$(*i*) of the adaptive filter 2 522 may be calculated according to the following equation.

[Equation 11]

$$e_2(i) = \underbrace{y(i) - \hat{\mathbf{h}}_1^H(i-1)\mathbf{x}_1(i)}_{y_{IC2}(i)} - \hat{\mathbf{h}}_2^H(i-1)\mathbf{x}_2(i)$$

The error of the adaptive filter 2 522 is a value obtained by subtracting the second interference estimation signal $\hat{y}_2$(*i*) from the second interference pre-cancellation signal $y_{IC2}$(*i*). Also, in some embodiments, the adaptive filter 2 522 may calculate a gain vector $\mathbf{k}_2$(*i*) of a current sample based on a forgetting factor corresponding to the adaptive filter 2 522, the second interference model signal $\mathbf{x}_2$(*i*), and an inverse matrix $\mathbf{P}_2$(*i* - 1) of a covariance matrix of a previous sample. For example, the gain vector $\mathbf{k}_2$(*i*) of the adaptive filter 2 522 may be based on the following equation.

[Equation 12]

$$\mathbf{k}_2(i) = \frac{\mathbf{P}_2(i-1)\mathbf{x}_2(i)}{\lambda_2 + \mathbf{x}_2^H(i)\mathbf{P}_2(i-1)\mathbf{x}_2(i)}$$

Here, $\lambda_2$ is a forgetting factor of the adaptive filter 2 522, $\mathbf{P}_2$(*i* - 1) is an inverse matrix of a covariance matrix in the (i-1)th sample, and $\mathbf{x}_2^H(i)$ is a Hermitian transpose of the second interference model signal $\mathbf{x}_2$(*i*) for the ith sample. The forgetting factor $\lambda_2$ may be fixed (e.g. may be predefined). Alternatively, the forgetting factor $\lambda_2$ may be an integrated forgetting factor which is calculated (e.g. by the forgetting factor control circuit 610 of FIG. 6). When the gain vector $\mathbf{k}_2$(*i*) of the adaptive filter 2 522 is calculated, the adaptive filter 2 522 may calculate an inverse matrix $\mathbf{P}_2$(*i*) of a covariance matrix of a current sample based on the forgetting factor corresponding to the adaptive filter 2 522, the second interference model signal $\mathbf{x}_2$(*i*), and the inverse matrix $\mathbf{P}_2$(*i* - 1) of the covariance matrix of the previous sample. For example, an inverse matrix of the covariance matrix $\mathbf{P}_2$(*i*) in the ith sample may be updated according to the following equation.

[Equation 13]

$$\mathbf{P}_2(i) = \frac{1}{\lambda_2}[\mathbf{P}_2(i-1) - \mathbf{k}_2(i)\mathbf{x}_2^H(i)\mathbf{P}_2(i-1)]$$

That is, the inverse matrix of the covariance matrix $\mathbf{P}_2$(*i*) in the ith sample may be updated based on the gain vector $\mathbf{k}_2$(*i*) of the adaptive filter 2 522, the forgetting factor $\lambda_2$ of the adaptive filter 2 522, the second interference model signal $\mathbf{x}_2$(*i*), and the inverse matrix of the covariance matrix $\mathbf{P}_2$(*i* - 1) of the previous sample.

According to an embodiment, in the next sample (e.g., the (i+1)th sample), an error $e_2$(*i* + 1) of the adaptive filter 2 522 may be updated by repeatedly calculating Equations 10 to 13 described above. As calculation is repeatedly performed according to samples, an error of the adaptive filter 1 521 may be reduced, and thus, multiple interference may be cancelled.

In operation S450, the multiple interference cancellation circuit 300 may output a filtering signal by subtracting the plurality of interference pre-cancellation signals from the reception signal. To this end, the multiple interference cancellation circuit 300 may further include a summer 530. The summer 530 may output a filtering signal by inverting a sign of the first interference estimation signal $\hat{y}_1$(*i*) received from the adaptive filter 1 521, inverting a sign of the second interference

estimation signal $\hat{y}_2(i)$ received from the adaptive filter 2 522, and adding a result to the reception signal $y(i)$. Accordingly, the summer 530 may subtract the first interference estimation signal $\hat{y}_1(i)$ and the second interference estimation signal $\hat{y}_2(i)$ from the reception signal $y(i)$.

Although operations S410 to S450 are sequentially performed in the above, embodiments are not limited thereto. For example, in some embodiments, operations S430 to S440 in which a plurality of interference pre-cancellation signals are generated and filter coefficients of a plurality of adaptive filters are updated and operation S450 in which a filtering signal is output may be performed in parallel.

FIG. 6 is a diagram illustrating an example of a multiple interference cancellation circuit, according to an embodiment.

Referring to FIG. 6, a multiple interference cancellation circuit (e.g., the multiple interference cancellation circuit 300 of FIG. 3) may operate in a first operation mode. The first operation mode may be an operation mode in which an integrated forgetting factor is calculated by considering not only an interference estimation error based on a transmission signal but also a pre-cancellation error caused by pre-cancelling interference estimation signals of other adaptive filters. In order to calculate the integrated forgetting factor, the multiple interference cancellation circuit 300 may further include a forgetting factor control circuit 610. In an embodiment, the forgetting factor control circuit 610 of FIG. 6 may correspond to the forgetting factor control circuit 330 of FIG. 3.

According to an embodiment, each of the number of a plurality of transmission signals, the number of a plurality of kernel generation circuits, and the number of a plurality of adaptive filters may be N. Here, N is a natural number. However, embodiments are not limited thereto, and in some embodiments, the number of the plurality of transmission signals may be M different from N.

According to an embodiment, referring to FIGS. 6 and 5 together, the summer 531 and the summer 532 of FIG. 5 may be omitted in the embodiment of FIG. 6. In place of the omitted summer 531 and the summer 532, an output signal of the summer 530 may be fed back to the plurality of adaptive filters (E.G., 521 and 522). This configuration is because Equation 7 of the error $e_1(i)$ corresponding to the adaptive filter 1 521 and Equation 11 of the error $e_2(i)$ corresponding to the adaptive filter 2 522 are the same as a filtering signal, which is an output of the summer 530.

In the first operation mode, the forgetting factor control circuit 330 may calculate a forgetting factor based on an interference estimation error and a pre-cancellation error, and the calculated forgetting factor may be commonly applied to the plurality of adaptive filters 320. According to an embodiment, when there are two interference channels, an integrated forgetting factor $\lambda(i)$ may be calculated according to the following equation.

[Equation 14]

$$\lambda(i) = min \left\{ \frac{\frac{1}{2}(\hat{\sigma}_{q,1}(i) + \hat{\sigma}_{q,2}(i))\hat{\sigma}_v}{\xi + |\hat{\sigma}_e(i) - \hat{\sigma}_v(i)|} + \sqrt{\left\{ \frac{\frac{1}{2}(\hat{\sigma}_{q,1}(i) + \hat{\sigma}_{q,2}(i))\hat{\sigma}_v}{\xi + |\hat{\sigma}_e(i) - \hat{\sigma}_v(i)|} \right\}^2 + \frac{(\hat{\sigma}_e(i) + \hat{\sigma}_v)}{\xi + |\hat{\sigma}_e(i) - \hat{\sigma}_v(i)|}\hat{\sigma}_{q,1}(i)\hat{\sigma}_{q,2}(i)}, \lambda_{max} \right\}$$

$\lambda_{max}$ may be a maximum integrated forgetting factor (e.g. a predefined limit for the forgetting factor). Further terms of Equation 14 may correspond to the following equations.

[Equation 15]

$$\hat{\sigma}_e(i) = \alpha\hat{\sigma}_e(i-1) + (1-\alpha)e^2(i)$$

[Equation 16]

$$\hat{\sigma}_{q,1}(i) = \alpha\hat{\sigma}_{q,1}(i-1) + (1-\alpha)q_1{}^2(i)$$

[Equation 17]

$$\hat{\sigma}_{q,2}(i) = \alpha\hat{\sigma}_{q,2}(i-1) + (1-\alpha)q_2{}^2(i)$$

[Equation 18]

$$\hat{\sigma}_v(i) = \beta\hat{\sigma}_v(i-1) + (1-\beta)e^2(i)$$

In Equations 15 to 17, $q_1$ and $q_2$ may correspond to the following equations.

[Equation 19]

$$q_1 = \mathbf{x}_1^H(i)\mathbf{P}_1(i-1)\mathbf{x}_1(i)$$

[Equation 20]

$$q_2 = \mathbf{x}_2^H(i)\mathbf{P}_2(i-1)\mathbf{x}_2(i)$$

Here, § is greater than 0, $\alpha = 1 - \frac{1}{K_\alpha L}$, and $\beta = 1 - \frac{1}{K_\beta L}$ . In this case, $K_\beta > K_\alpha$. $\xi$, $K_\beta$ and $K_\alpha$ may be predefined coefficients. Also, $L$ is the number of filter taps of each adaptive filter.

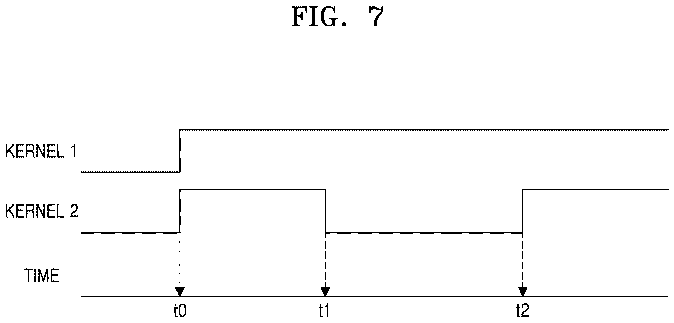

FIG. 7 is a diagram illustrating an example of occurrence of a pre-cancellation error, according to an embodiment.

Referring to FIG. 7, an example of a change in a first kernel signal Kernel 1 and a second kernel signal Kernel 2 over time is illustrated. For convenience of explanation, the following will be described assuming that the electronic device 1 includes a first kernel generation circuit (e.g., the kernel generation circuit 1 511 of FIG. 5) and a second kernel generation circuit (e.g., the kernel generation circuit 2 512 of FIG. 5).

According to an embodiment, the first kernel signal Kernel 1 may correspond to the first interference model signal $\mathbf{x}_1(i)$ output from the kernel generation circuit 1 511, and the second kernel signal Kernel 2 may correspond to the second interference model signal $\mathbf{x}_2$(i) output from the kernel generation circuit 2 512.

According to an embodiment, at time t0, the first kernel signal Kernel 1 and the second kernel signal Kernel 2 may be generated. As a combination of frequency bands available in Evolved UMTS Radio Access Network (E-UTRAN) new radio - dual connectivity (ENDC) or carrier aggregation (CA) increases, multiple interference may occur. Thereafter, filter coefficients of adaptive filters may be updated over several samples from time t0, and the filter coefficients may converge before time t1.

According to an embodiment, at time t1, the second kernel signal Kernel 2 may disappear. For example, the second kernel signal Kernel 2 may disappear based on a state change (e.g., from logic high to logic low) of at least one signal from among a plurality of transmission signals (e.g., TX 1 to TX N of FIG. 6). Referring to Equations 1 to 3, it is found that an adaptive filter generates an interference estimation signal based on a previous sample, not a current sample. Accordingly, even though the second kernel signal Kernel 2 disappears at time t1, interference may be cancelled by using a filter coefficient corresponding to the previous sample corresponding to a state in which the second kernel signal Kernel 2 exists, resulting in a pre-cancellation error. Thereafter, filter coefficients of adaptive filters over several samples may be updated from time t1, and thus, the filter coefficients may converge before time t2.

According to an embodiment, at time t2, the second kernel signal Kernel 2 may appear again. For example, the second kernel signal Kernel 2 may appear based on a state change (e.g., from logic low to logic high) of at least one signal from among the plurality of transmission signals (e.g., TX 1 to TX N of FIG. 6). Referring to Equations 1 to 3, it is found that an adaptive filter generates an interference estimation signal based on a previous sample, not a current sample. Accordingly, even though the second kernel signal Kernel 2 appears again at time t2, interference may be cancelled by using a filter coefficient of the previous sample corresponding to a state where the second kernel signal Kernel 2 does not exist, resulting in a pre-cancellation error.

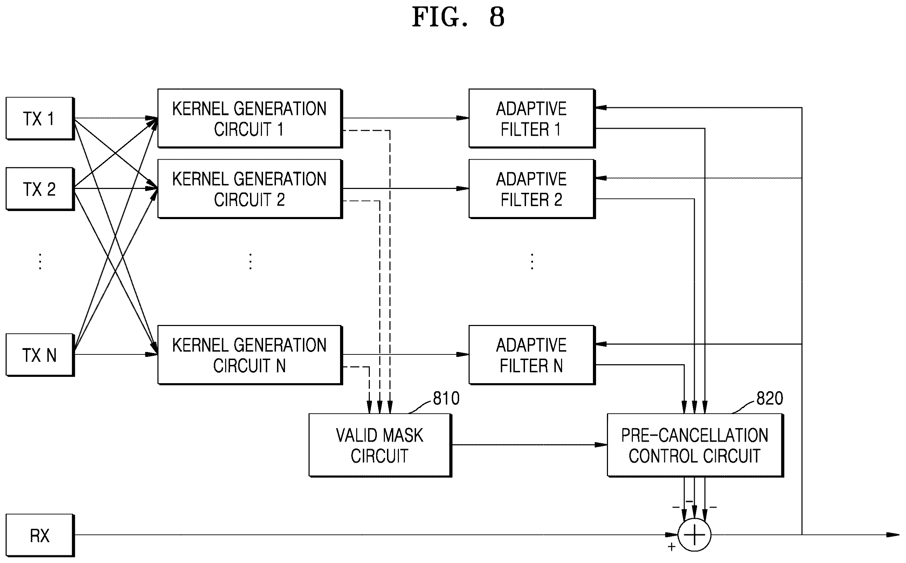

FIG. 8 is a diagram illustrating an example of a multiple interference cancellation circuit, according to an embodiment.

Referring to FIG. 8, a multiple interference cancellation circuit (e.g., the multiple interference cancellation circuit 300) may operate in a second operation mode. The second operation mode may be an operation mode for controlling whether to cancel each interference during pre-cancellation using a mask signal. According to an embodiment, the multiple interference cancellation circuit 300 may further include a valid mask circuit 810 and a pre-cancellation control circuit 820.

According to an embodiment, each of the number of a plurality of transmission signals, the number of a plurality of kernel generation circuits, and the number of a plurality of adaptive filters may be N. Here, N is a natural number. However, embodiments are not limited thereto, and in some embodiments, the number of the plurality of transmission signals may be M different from N.

According to an embodiment, the valid mask circuit 810 may receive control signals from the plurality of kernel generation circuits. Each of the plurality of kernel generation circuits may provide to the valid mask circuit 810 a control signal indicating whether a corresponding interference model signal is received. For example, a first interference model signal may disappear based on disappearance of at least one of the plurality of transmission signals. A kernel generation circuit 1 may provide a control signal indicating that there is no first interference model signal corresponding to the kernel generation circuit 1 to the valid mask circuit 810. When there is no change in a second interference model signal to an $N^{th}$ interference model signal, a kernel generation circuit 2 to a kernel generation circuit N may provide control signals indicating that there are corresponding second to $N^{th}$ interference model signals to the valid mask circuit 810. The valid mask circuit 810 may determine which interference model signal has disappeared or appeared based on the control signals and may output a pre-cancellation control signal to the pre-cancellation control circuit 820.

The pre-cancellation control circuit 820 may determine interference to be pre-cancelled, based on the pre-cancellation control signal received from the valid mask circuit 810. For example, when a second transmission signal TX 2 disappears, pre-cancellation of a plurality of interference signals (e.g., intermodulation interference due to a combination between the second transmission signal TX 2 and other transmission signals) caused by the second transmission signal TX 2 may be omitted. In another example, when the second transmission signal TX 2 appears, pre-cancellation of a plurality of interference signals (e.g., intermodulation interference due to a combination between the second transmission signal TX 2 and other transmission signals) caused by the second transmission signal TX2 may be added.

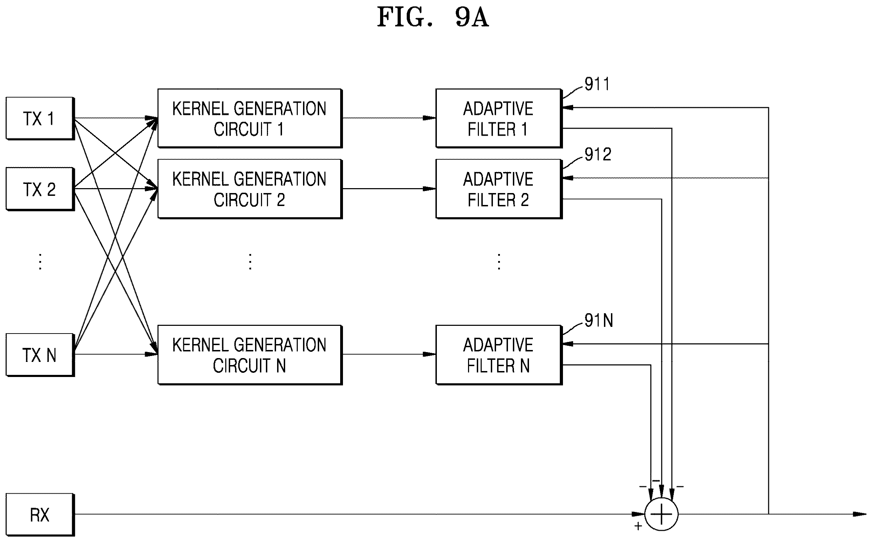

FIG. 9A is a diagram illustrating an example of a multiple interference cancellation circuit, according to an embodiment.

Referring to FIG. 9A, a multiple interference cancellation circuit (e.g., the multiple interference cancellation circuit 300 of FIG. 3) may include a plurality of adaptive filters. The plurality of adaptive filters may include an adaptive filter 1 911, an adaptive filter 2 912 to an adaptive filter N 91N.

According to an embodiment, the adaptive filter 1 911 to the adaptive filter N 91N of FIG. 9A may be different from a plurality of adaptive filters of FIGS. 5, 6, and 8. For example, the number of filter taps of each of the plurality of adaptive filters of FIGS. 5, 6, and 7 may be F. The number of filter taps of each of the adaptive filter 1 911 to the adaptive filter N 91N of FIG. 9A may be F+1. The reason why the number of filter taps of each of the adaptive filter 1 911 to the adaptive filter N 91N is added by 1 may be that a tap for adjusting a magnitude of interference to be pre-cancelled is added. For example, a pre-cancellation error $e_{IC1}(i)$ of the adaptive filter 1 911 may be as follows.

[Equation 21]

$$e_{IC1}(i) = y(i) - \hat{y}_1(i)$$

Here, $y(i)$ is a reception signal, and $\hat{y}_1(i)$ is an interference estimation signal output from the adaptive filter 1 911. The interference estimation signal $\hat{y}_1(i)$ corresponding to the adaptive filter 1 911 having F+1 filter taps may be calculated according to the following equation.

[Equation 22]

$$[0122] \qquad \hat{y}_1(i) = \begin{bmatrix} \hat{\mathbf{h}}_1^H(i-1) & \hat{h}_{IC1} \end{bmatrix} \begin{bmatrix} \mathbf{x}_1(i) \\ \hat{\mathbf{h}}_2^H(i-1)\mathbf{x}_2(i) \end{bmatrix}$$

Here, $\hat{h}_{IC1}$ is a filter coefficient for an interference pre-cancellation signal $y_{IC1}(i)$ input to the adaptive filter 1 911. Although complexity may increase slightly because the number of filter taps of each of the adaptive filter 1 911 to the adaptive filter N 911 is increased by 1, an overall mean square error (MSE) may be reduced.

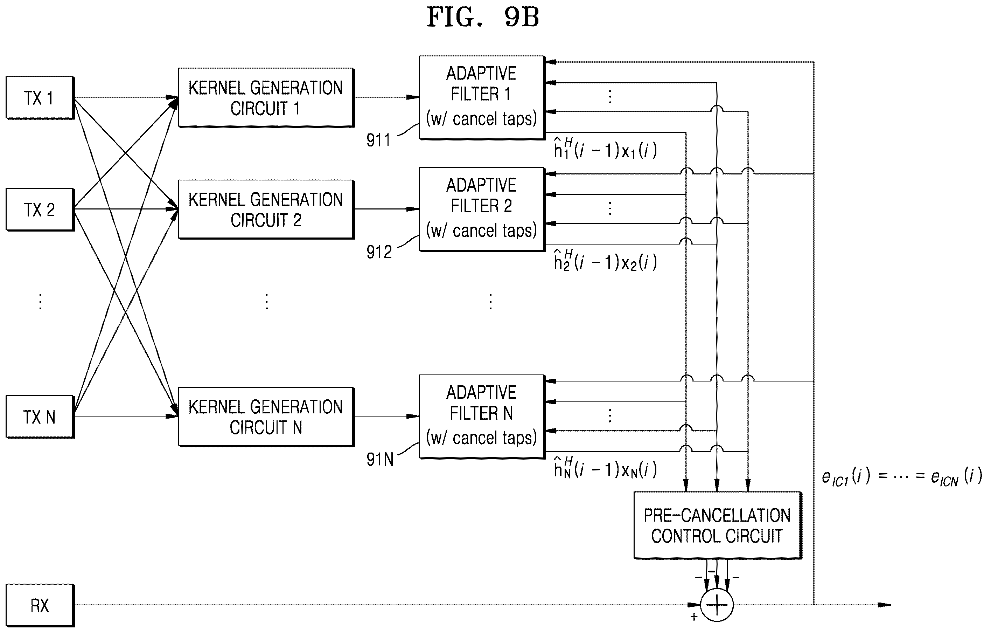

FIG. 9B is a diagram illustrating an example of a multiple interference cancellation circuit, according to an embodiment.

Referring to FIG. 9B, a multiple interference cancellation circuit (e.g., the multiple interference cancellation circuit 300) may include a plurality of adaptive filters. The plurality of adaptive filters may include an adaptive filter 1 911, an adaptive filter 2 912 to an adaptive filter N 91N.

According to an embodiment, the adaptive filter 1 911 to the adaptive filter N 91N of FIG. 9B may be different from a plurality of adaptive filters of FIGS. 5, 6, and 8. For example, the number of filter taps of each of the plurality of adaptive filters of FIGS. 5, 6, and 8 may be F. The number of filter taps of each of the adaptive filter 1 911 to the adaptive filter N 91N of FIG. 9B may be F+N-1. The reason why the number of filter taps of each of the adaptive filter 1 911 to the adaptive filter N 91N is increased by N-1 may be that a tap for adjusting a magnitude of interference to be pre-cancelled is added. For example, a pre-cancellation error $e_{ICN}(i)$ of the adaptive filter 1 911 is as follows.

[Equation 23]

$$e_{IC1}(i) = \cdots = e_{ICN}(i) = y(i) - \hat{y}_1(i) - \cdots - \hat{y}_N(i)$$

Here, $y(i)$ is a reception signal, and $\hat{y}_N(i)$ is an interference estimation signal output from the adaptive filter N 91N. An interference estimation signal $\hat{y}_1(i)$ corresponding to the adaptive filter 1 911 having F+N-1 filter taps may be calculated according to the following equation.

[Equation 24]

$$\hat{y}_1(i) = \begin{bmatrix} \hat{\mathbf{h}}_1^H(i-1) & \hat{h}_{IC1,2}^H(i-1) & \cdots & \hat{h}_{IC1,N}^H(i-1) \end{bmatrix} \begin{bmatrix} \mathbf{x}_1(i) \\ \hat{\mathbf{h}}_2^H(i-1)\mathbf{x}_2(i) \\ \vdots \\ \hat{\mathbf{h}}_N^H(i-1)\mathbf{x}_N(i) \end{bmatrix}$$

Here, $\hat{h}_{IC1,2}^H, \ldots, \hat{h}_{IC1,N}^H$ are channel coefficients (e.g., the conjugate transpose of the filter coefficients) corresponding to inputs from the adaptive filter 2 912 to the adaptive filter N 91N. Although complexity may increase slightly because the number of filter taps of each of the adaptive filter 1 911 to the adaptive filter N 91N is increased by N-1, an overall MSE may be reduced.

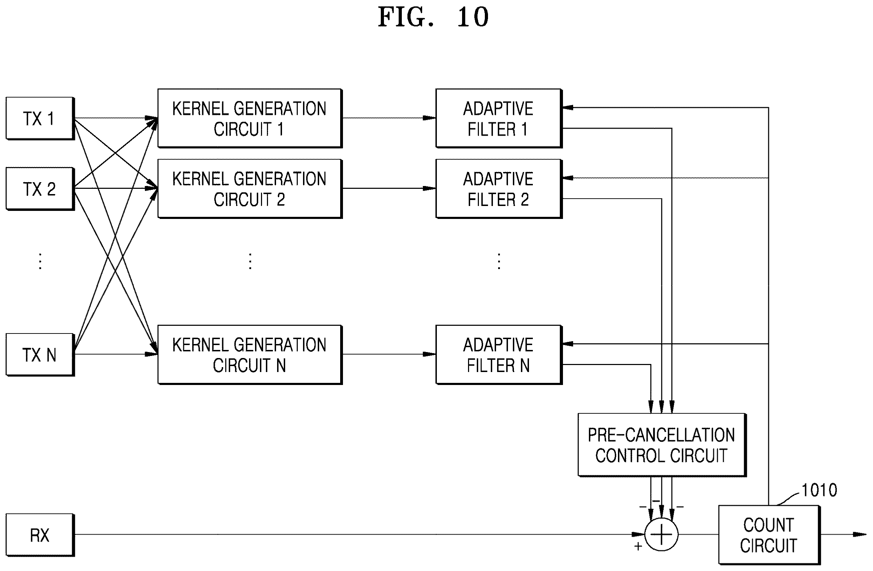

FIG. 10 is a diagram illustrating an example of a multiple interference cancellation circuit, according to an embodiment.

Referring to FIG. 10, a multiple interference cancellation circuit (e.g., the multiple interference cancellation circuit 300 of FIG. 3) may include a count circuit 1010. The multiple interference cancellation circuit (e.g., the multiple interference cancellation circuit 300 of FIG. 3) may operate in a third operation mode. The third operation mode may be an operation mode in which calculation of a filter coefficient is repeated. For example, the multiple interference cancellation circuit 300 of FIG. 3 may perform updating based on a filter coefficient of a previous sample, while the multiple interference cancellation circuit 300 of FIG. 10 may increase the accuracy of a filter coefficient by repeatedly calculating a filter coefficient of a current sample. To this end, the multiple interference cancellation circuit 300 may include the count circuit 1010.

According to an embodiment, the count circuit 1010 may receive count information. The count information may be control information indicating how many times to repeat calculation of a filter coefficient. For example, when the count information is "3", the count circuit 1010 may control the multiple interference cancellation circuit 300 to repeat calculation of a filter coefficient three times in a current sample. The count circuit 1010 may receive a filtering signal from a summer and may determine whether a count number matches the count information. When the count number does not match the count information, because calculation of a filter coefficient should be further repeated, the received filtering signal may be fed back to an adaptive filter 1 to an adaptive filter N. The count circuit 1010 may receive a filtering signal, and may determine again whether a count number matches the count information. When the count number matches the count information, the count circuit 1010 may determine that repeated calculation of a filter coefficient has been completed. The count circuit 1010 may output a filtering signal, in response to the count number matching the count information. For example, the multiple interference cancellation circuit 300 including the adaptive filter 1 and the adaptive filter 2 may be assumed. A filter coefficient and a pre-cancellation error corresponding to the adaptive filter 1 and a filter coefficient and a pre-cancellation error corresponding to the adaptive filter 2 are as shown in the following equations.

[Equation 25]

$$\hat{\mathbf{h}}_1(i,k) = \hat{\mathbf{h}}_1(i,k-1) + \mathbf{k}_1(i)e_{IC1}^*(i,k)$$

[Equation 26]

$$e_{IC1}(i,k) = y(i) - \hat{\mathbf{h}}_2^H(i,k-1)\mathbf{x}_2(i) - \hat{\mathbf{h}}_1^H(i,k-1)\mathbf{x}_1(i)$$

[Equation 27]

$$\hat{\mathbf{h}}_2(i,k) = \hat{\mathbf{h}}_2(i,k-1) + \mathbf{k}_2(i)e_{IC2}^*(i,k)$$

[Equation 28]

$$e_{IC2}(i,k) = y(i) - \hat{\mathbf{h}}_2^H(i,k-1)\mathbf{x}_2(i) - \hat{\mathbf{h}}_1^H(i,k-1)\mathbf{x}_1(i)$$

Here, k may correspond to a repetition index.

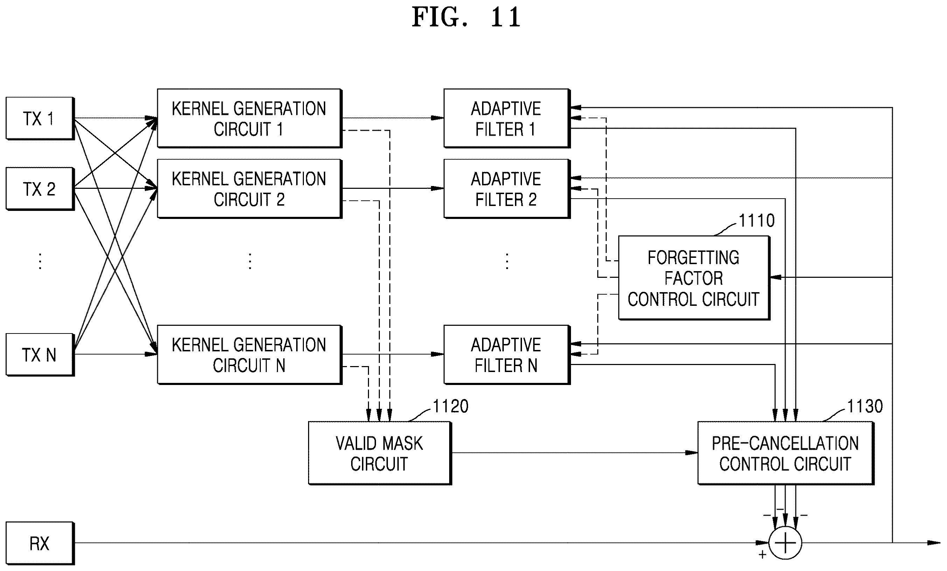

According to various embodiments, two or more operation modes may simultaneously operate to further improve interference cancellation performance, which will be described below with reference to FIGS. 11 to 13.

FIG. 11 is a diagram illustrating an example of a multiple interference cancellation circuit, according to an embodiment.

Referring to FIG. 11, a multiple interference cancellation circuit (e.g., the multiple interference cancellation circuit 300 of FIG. 3) may be based on a first operation mode and a second operation mode. The multiple interference cancellation circuit 300 may include a forgetting factor control circuit 1110, a valid mask circuit 1120, and a pre-cancellation control circuit 1130.

According to an embodiment, the forgetting factor control circuit 1110 may calculate a forgetting factor based on an interference estimation error and a pre-cancellation error, and the calculated forgetting factor may be commonly applied to an adaptive filter 1 to an adaptive filter N.

According to an embodiment, the valid mask circuit 1120 may receive control signals from a kernel generation circuit 1 to a kernel generation circuit N. Each of the kernel generation circuit 1 to the kernel generation circuit N may provide a control signal indicating whether a corresponding interference model signal is received to the valid mask circuit 1120. For example, a first interference model signal may disappear based on disappearance of at least one of a plurality of transmission signals. The kernel generation circuit 1 may provide a control signal indicating that there is no first interference model signal corresponding to the kernel generation circuit 1 to the valid mask circuit 1120. When there is no change in a second interference model signal to an $N^{th}$ interference model signal, the kernel generation circuit 2 to the kernel generation circuit N may provide control signals indicating that there are the second interference model signal to the $N^{th}$ interference model signal to the valid mask circuit 1120. The valid mask circuit 1120 may determine which interference model signal has disappeared or appeared based on the control signals and may output a pre-cancellation control signal to the pre-cancellation control circuit 1130.

The pre-cancellation control circuit 1130 may determine interference to be pre-cancelled, based on the pre-cancellation control signal received from the valid mask circuit 1120. For example, when the second interference model signal disappears, pre-cancellation of the second interference model signal may be omitted. In another example, when the second interference model signal appears, non-reflection of the second interference model signal may be prevented. For instance, when the second interference model signal appears, pre-cancellation of a plurality of interference signals (e.g., intermodulation interference due to a combination between the second transmission signal TX 2 and other transmission signals) caused by the second transmission signal TX2 may be added.

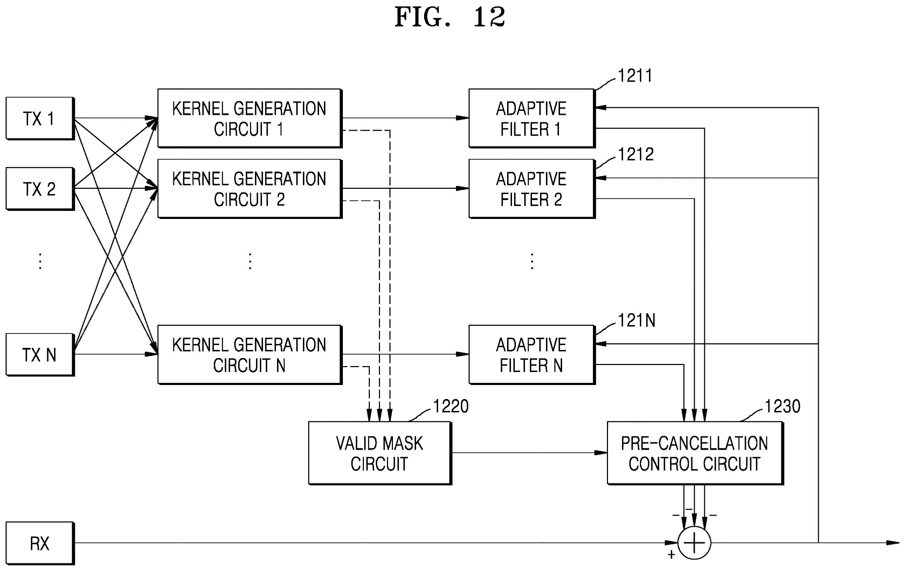

FIG. 12 is a diagram illustrating an example of a multiple interference cancellation circuit, according to an embodiment.

Referring to FIG. 12, a multiple interference cancellation circuit (e.g., the multiple interference cancellation circuit 300 of FIG. 3) may include an adaptive filter 1 1211 to an adaptive filter N 121N, a valid mask circuit 1220, and a pre-cancellation control circuit 1230.

According to an embodiment, the adaptive filter 1 1211 to the adaptive filter N 121N may be different from a plurality of adaptive filters of FIGS. 5, 6, and 8. For example, the number of filter taps of each of the plurality of adaptive filters of FIGS. 5, 6, and 8 may be F. The number of filter taps of each of the adaptive filter 1 1211 to the adaptive filter N 121N may be F+1. The adaptive filters of FIG. 12 may function similarly to the adaptive filters of FIG. 9A. The number of filter taps of each of the adaptive filter 1 1211 to the adaptive filter N 121N may be increased by 1, to reduce an overall MSE.

According to an embodiment, the valid mask circuit 1220 may receive control signals from a kernel generation circuit 1 to a kernel generation circuit N. Each of the kernel generation circuit 1 to the kernel generation circuit N may provide a control signal indicating whether a corresponding interference model signal is received to the valid mask circuit 1220. For example, a first interference model signal may disappear based on disappearance of at least one of a plurality of transmission signals. The kernel generation circuit 1 may provide a control signal indicating that there is no first interference model signal corresponding to the kernel generation circuit 1 to the valid mask circuit 1220. When there is no change in a second interference model signal to an $N^{th}$ interference model signal, the kernel generation circuit 2 to the kernel generation circuit N may respectively provide control signals indicating that there are the second interference model signal to the $N^{th}$ interference model signals to the valid mask circuit 1220. The valid mask circuit 1220 may determine which interference model signal has disappeared or appeared based on the control signals and may output a pre-cancellation control signal to the pre-cancellation control circuit 1230.

The pre-cancellation control circuit 1230 may determine interference to be pre-cancelled, based on the pre-cancellation control signal received from the valid mask circuit 1220. For example, when the second interference model signal disappears, pre-cancellation of the second interference model signal may be omitted. In another example, when the second interference model signal appears, non-reflection of the second interference model signal may be prevented. For instance, when the second interference model signal appears, pre-cancellation of a plurality of interference signals (e.g., intermodulation interference due to a combination between the second transmission signal TX 2 and other transmission signals) caused by the second transmission signal TX2 may be added.

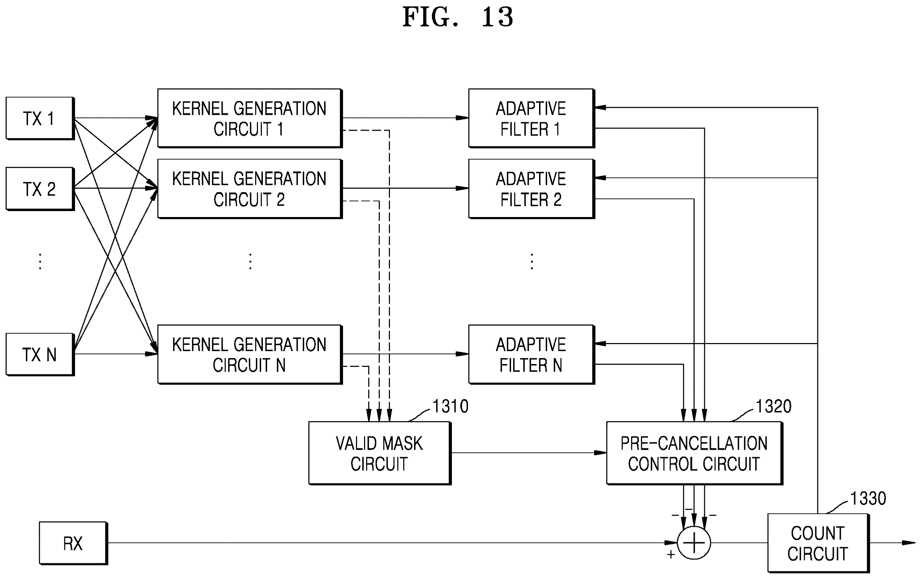

FIG. 13 is a diagram illustrating an example of a multiple interference cancellation circuit, according to an embodiment.

Referring to FIG. 13, a multiple interference cancellation circuit (e.g., the multiple interference cancellation circuit 300 of FIG. 3) may be based on both a second operation mode and a third operation mode. The multiple interference cancellation circuit (e.g., the multiple interference cancellation circuit 300 of FIG. 3) may include a valid mask circuit 1310, a pre-cancellation control circuit 1320, and a count circuit 1330.

According to an embodiment, the valid mask circuit 1310 may receive control signals from a kernel generation circuit 1 to a kernel generation circuit N. Each of the kernel generation circuit 1 to the kernel generation circuit N may provide a control signal indicating whether a corresponding interference model signal is received to the valid mask circuit 1310. For example, a first interference model signal may disappear based on disappearance of at least one of a plurality of transmission signals. The kernel generation circuit 1 may provide a control signal indicating that there is no first interference model signal corresponding to the kernel generation circuit 1 to the valid mask circuit 1310. When there is no change in a second interference model signal to an $N^{th}$ interference model signal, the kernel generation circuit 2 to the kernel generation circuit N may respectively provide control signals indicating that there are the second to $N^{th}$ interference model signals to the valid mask circuit 1310. The valid mask circuit 1310 may determine which interference model signal has disappeared or appeared based on the control signals and may output a pre-cancellation control signal to the pre-cancellation control circuit 1320.

The pre-cancellation control circuit 1320 may determine interference to be pre-cancelled, based on the pre-cancellation control signal received from the valid mask circuit 1310. For example, when the second interference model signal disappears, pre-cancellation of the second interference model signal may be omitted. In another embodiment, when the second interference model signal appears, non-reflection of the second interference model signal may be prevented. For instance, when the second interference model signal appears, pre-cancellation of a plurality of interference signals (e.g., intermodulation interference due to a combination between the second transmission signal TX 2 and other transmission signals) caused by the second transmission signal TX2 may be added.

According to an embodiment, the count circuit 1330 may increase the accuracy of a filter coefficient by repeatedly calculating a filter coefficient of a current sample. The count circuit 1330 may receive count information. The count information may be control information indicating how many times to repeat calculation of a filter coefficient. For example, when the count information is "3", the count circuit 1330 may control the multiple interference cancellation circuit 300 to repeat calculation of a filter coefficient three times in the current sample. The count circuit 1330 may receive a filtering signal from a summer and may determine whether a count number matches the count information. When the count number does not match the count information, because calculation of a filter coefficient should be further repeated, the received filtering signal may be fed back to an adaptive filter 1 to an adaptive filter N. Next, the count circuit 1330 may receive a filtering signal and may determine again whether a count number matches the count information. When the count number matches the count information, the count circuit 1330 may determine that repeated calculation of a filter coefficient has been completed. The count circuit 1330 may output a filtering signal, in response to the count number matching the count information.

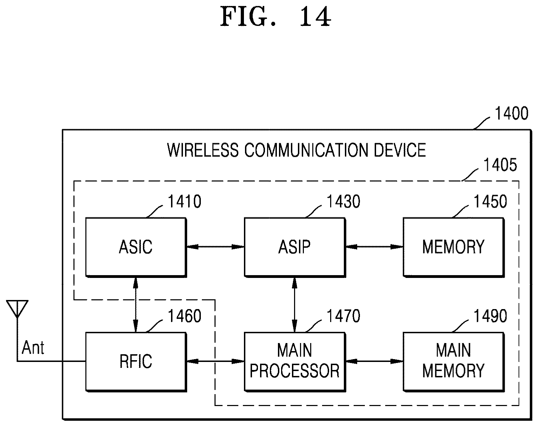

FIG. 14 is a block diagram illustrating a wireless communication device, according to an embodiment.

Referring to FIG. 14, a wireless communication device 1400 may include a modem 1405 and a radio frequency integrated circuit (RFIC) 1460, and the modem 1405 may include an application-specific integrated circuit (ASIC) 1410, an application-specific instruction set processor (ASIP) 1430, a memory 1450, a main processor 1470, and a main memory 1490. In some embodiments, the wireless communication device 1400 of FIG. 14 may be the electronic device 1 according to an embodiment.

The RFIC 1460 may be connected to an antenna Ant to receive a signal from the outside or transmit a signal to the outside by using a wireless communication network. The ASIP 1430 may be a customized integrated circuit for a specific purpose such as for multiple interference cancellation described above with reference to FIGS. 1-13, and may support an instruction set for a specific application and may execute instructions included in the instruction set. The memory 1450 may communicate with the ASIP 1430 and may store, as a non-transitory storage device, a plurality of instructions executed by the ASIP 1430 to implement multiple interference cancellation as described above with reference to FIGS. 1-13 and/or, for example, to perform the operations S410-S450 of FIG. 4. For example, the memory 1450 may include any type of memory accessible by the ASIP 1430, such as, but not limited to, a randomaccess memory (RAM), a read-only memory (ROM), a tape, a magnetic disk, an optical disk, a volatile memory, a nonvolatile memory, and/or a combination thereof.

The main processor 1470 may control the wireless communication device 1400 by executing a plurality of instructions. For example, the main processor 1470 may control the ASIC 1410 and the ASIP 1430, and may process data received through the wireless communication network or process a user input to the wireless communication device 1400.

The main memory 1490 may communicate with the main processor 1470, and may store, as a non-transitory storage device, a plurality of instructions executed by the main processor 1470. For example, the main memory 1490 may include any type of memory accessible by the main processor 1470, such as, but not limited to, a RAM, a ROM, a tape, a magnetic disk, an optical disk, a volatile memory, a nonvolatile memory, and/or a combination thereof.

As described above, embodiments have been illustrated in the drawings and described in the specification. While embodiments have been described using specific terms, these terms are only used for the purpose of explaining the various embodiments and not used to limit the meaning and scope of the appended claims. Hence, it will be understood by one of ordinary skill in the art that various modifications and other equivalent embodiments may be made therefrom. Accordingly, the technical scope of the present disclosure should be defined by the following claims.

While various embodiments been particularly shown and described with reference to the drawings, it will be understood that various changes in form and details may be made therein without departing from the scope of the following claims.

**Claims**

1. A multiple interference cancellation circuit comprising:

   a first kernel generation circuit (511) configured to receive a plurality of transmission signals and, based on the plurality of transmission signals, generate a first interference model signal;
   a second kernel generation circuit (512) configured to receive the plurality of transmission signals and, based on the plurality of transmission signals, generate a second interference model signal different from the first interference model signal;
   a first adaptive filter (521) configured to receive the first interference model signal from the first kernel generation circuit (511) and, based on the first interference model signal and a first filter coefficient, generate a first interference estimation signal;
   a second adaptive filter (522) configured to receive the second interference model signal from the second kernel generation (512) circuit and, based on the second interference model signal and a second filter coefficient, generate a second interference estimation signal; and
   a first summer (530) configured to output a filtering signal obtained by subtracting the first interference estimation signal and the second interference estimation signal from a reception signal.

2. The multiple interference cancellation circuit of claim 1, further comprising a second summer (532) configured to receive the second interference estimation signal from the second adaptive filter (522) and the reception signal, generate a first interference pre-cancellation signal by subtracting the second interference estimation signal from the reception signal, and provide the first interference pre-cancellation signal to the first adaptive filter (521).

3. The multiple interference cancellation circuit of claim 2, wherein the first adaptive filter (521) is further configured to:

   calculate a first gain vector of a current sample, based on a first forgetting factor corresponding to the first adaptive filter (521), the first interference model signal, and an inverse matrix of a first covariance matrix of a previous sample; and
   update a first filter coefficient of the current sample, based on a first filter coefficient of the previous sample, the first gain vector of the current sample, and a first error obtained by subtracting the first interference estimation signal from the first interference pre-cancellation signal.

4. The multiple interference cancellation circuit of claim 3, wherein the first adaptive filter (521) is further configured to update an inverse matrix of a first covariance matrix of the current sample, based on the first forgetting factor, the first interference model signal, and the inverse matrix of the first covariance matrix of the previous sample.

5. The multiple interference cancellation circuit of any preceding claim, further comprising a third summer (531) configured to receive the first interference estimation signal from the first adaptive filter (521) and the reception signal, generate a second interference pre-cancellation signal by subtracting the first interference estimation signal from the reception signal, and provide the second interference pre-cancellation signal to the second adaptive filter (522).

6. The multiple interference cancellation circuit of claim 5, wherein the second adaptive filter (522) is further configured to:

calculate a second gain vector of a current sample, based on a second forgetting factor corresponding to the second adaptive filter (522), the second interference model signal, and an inverse matrix of a second covariance matrix of a previous sample; and

update a second filter coefficient of the current sample, based on a second filter coefficient of the previous sample, the second gain vector of the current sample, and a second error obtained by subtracting the second interference estimation signal from the second interference pre-cancellation signal.

7. The multiple interference cancellation circuit of claim 6, wherein the second adaptive filter (522) is further configured to update an inverse matrix of a second covariance matrix of the current sample, based on the second forgetting factor, the second interference model signal, and the inverse matrix of the second covariance matrix of the previous sample.

8. The multiple interference cancellation circuit of any preceding claim, wherein each of the first adaptive filter (521) and the second adaptive filter (522) is a recursive least square filter, and

wherein the first adaptive filter (521) and the second adaptive filter (522) are configured to simultaneously operate in parallel.

9. An operating method of a multiple interference cancellation circuit, the operating method comprising:

in a first kernel generation circuit (511), receiving a plurality of transmission signals and, based on the plurality of transmission signals, generating a first interference model signal;

in a second kernel generation circuit (512), receiving the plurality of transmission signals and, based on the plurality of transmission signals, generating a second interference model signal different from the first interference model signal;

in a first adaptive filter (521), receiving the first interference model signal from the first kernel generation circuit (511) and generating a first interference estimation signal based on the first interference model signal and a first filter coefficient;

in a second adaptive filter (522), receiving the second interference model signal from the second kernel generation circuit (512) and generating a second interference estimation signal based on the second interference model signal and a second filter coefficient; and

outputting a filtering signal obtained by subtracting the first interference estimation signal and the second interference estimation signal from a reception signal.

10. The operating method of claim 9, further comprising:

receiving the second interference estimation signal from the second adaptive filter (522), and the reception signal;

generating a first interference pre-cancellation signal by subtracting the second interference estimation signal from the reception signal; and

providing the first interference pre-cancellation signal to the first adaptive filter (521).

11. The operating method of claim 10, further comprising:

in the first adaptive filter (521), calculating a first gain vector of a current sample, based on a first forgetting factor corresponding to the first adaptive filter (521), the first interference model signal, and an inverse matrix of a first covariance matrix of a previous sample; and

in the first adaptive filter (521), updating a first filter coefficient of the current sample, based on a first filter coefficient of the previous sample, the first gain vector of the current sample, and a first error obtained by subtracting the first interference estimation signal from the first interference pre-cancellation signal.

12. The operating method of claim 11, further comprising, in the first adaptive filter (521), updating an inverse matrix of a first covariance matrix of the current sample, based on the first forgetting factor, the first interference model signal, and the inverse matrix of the first covariance matrix of the previous sample.

13. The operating method of any of claims 9-12, further comprising:

> receiving the first interference estimation signal from the first adaptive filter (521), and the reception signal;
> generating a second interference pre-cancellation signal by subtracting the first interference estimation signal from the reception signal; and
> providing the second interference pre-cancellation signal to the second adaptive filter (522).

14. The operating method of claim 13, further comprising:

> in the second adaptive filter (522), calculating a second gain vector of a current sample, based on a second forgetting factor corresponding to the second adaptive filter (522), the second interference model signal, and an inverse matrix of a second covariance matrix of a previous sample; and
> in the second adaptive filter (522), updating a second filter coefficient of the current sample, based on a second filter coefficient of the previous sample, the second gain vector of the current sample, and a second error obtained by subtracting the second interference estimation signal from the second interference pre-cancellation signal.

15. The operating method of claim 14, further comprising, in the second adaptive filter (522), updating an inverse matrix of a second covariance matrix of the current sample, based on the second forgetting factor, the second interference model signal, and the inverse matrix of the second covariance matrix of the previous sample.

# FIG. 1

# FIG. 2

EP 4 716 102 A1

# FIG. 3

21

# FIG. 4

```
┌─────────────────────────────────────────┐
│  GENERATE PLURALITY OF INTERFERENCE MODEL │──S410
│                 SIGNALS                   │
└─────────────────────────────────────────┘
                    │
                    ▼
┌─────────────────────────────────────────┐
│ GENERATE PLURALTIY OF INTERFERENCE ESTIMATION │──S420
│  SIGNALS BY USING PLURALITY OF ADAPTIVE FILTERS │
└─────────────────────────────────────────┘
                    │
                    ▼
┌─────────────────────────────────────────┐
│   GENERATE INTERFERENCE PRE-CANCELLATION  │
│  SIGNAL PROVIDED TO EACH OF PLURALITY OF  │──S430
│             ADAPTIVE FILTERS              │
└─────────────────────────────────────────┘
                    │
                    ▼
┌─────────────────────────────────────────┐
│      UPDATE PLURALITY OF ADAPTIVE FILTERS │
│        BASED ON PLURALITY OF INTERFERENCE │──S440
│           PRE-CANCELLATION SIGNALS        │
└─────────────────────────────────────────┘
                    │
                    ▼
┌─────────────────────────────────────────┐
│    OUTPUT FILTERING SIGNAL BY SUBTRACTING │
│  PLURALITY OF INTERFERENCE PRE-CANCELLATION │──S450
│        SIGNALS FROM RECEPTION SIGNAL       │
└─────────────────────────────────────────┘
```

# FIG. 5

# FIG. 6

FIG. 7

# FIG. 8

# FIG. 9A

EP 4 716 102 A1

## FIG. 9B

$$e_{IC1}(i) = \cdots = e_{ICN}(i)$$

# FIG. 10

EP 4 716 102 A1

FIG. 11

# FIG. 12

TX 1 → KERNEL GENERATION CIRCUIT 1 → ADAPTIVE FILTER 1 (1211)
TX 2 → KERNEL GENERATION CIRCUIT 2 → ADAPTIVE FILTER 2 (1212)
...
TX N → KERNEL GENERATION CIRCUIT N → ADAPTIVE FILTER N (121N)

VALID MASK CIRCUIT (1220)
PRE-CANCELLATION CONTROL CIRCUIT (1230)

RX

# FIG. 13

EP 4 716 102 A1

# FIG. 14

**EUROPEAN SEARCH REPORT**

Application Number

EP 25 20 3874

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/229884 A1 (XUE FENG [US] ET AL) 25 July 2019 (2019-07-25) * paragraphs [0040] - [0055], [0074], [0167]; figures 1,16 * ----- | 1-9, 11-15 | INV. H04B1/525 |
| X | US 2024/250854 A1 (KIM JOONTAE [KR] ET AL) 25 July 2024 (2024-07-25) * paragraphs [0048] - [0049] * ----- | 1-15 | |
| A | WO 2016/010770 A1 (QUALCOMM INC [US]) 21 January 2016 (2016-01-21) * paragraphs [0045] - [0049]; figure 3 * ----- | 1-15 | |

TECHNICAL FIELDS
SEARCHED     (IPC)

H04B

The present search report has been drawn up for all claims

| Place of search | Date of completion of the search | Examiner |
|---|---|---|
| Munich | 28 January 2026 | Marques, Gabriela |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..........................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 20 3874

This annex lists the patent family members relating to the patent documents cited in the above-mentioned European search report.
The members are as contained in the European Patent Office EDP file on
The European Patent Office is in no way liable for these particulars which are merely given for the purpose of information.

28-01-2026

| Patent document cited in search report | Publication date | Patent family member(s) | Publication date |
|---|---|---|---|
| US 2019229884 A1 | 25-07-2019 | CN 107645316 A | 30-01-2018 |
| | | EP 3273606 A1 | 24-01-2018 |
| | | US 2018026775 A1 | 25-01-2018 |
| | | US 2019229884 A1 | 25-07-2019 |
| | | US 2023344614 A1 | 26-10-2023 |
| | | WO 2018017143 A2 | 25-01-2018 |
| US 2024250854 A1 | 25-07-2024 | EP 4404460 A2 | 24-07-2024 |
| | | TW 202431776 A | 01-08-2024 |
| | | US 2024250854 A1 | 25-07-2024 |
| WO 2016010770 A1 | 21-01-2016 | US 9197264 B1 | 24-11-2015 |
| | | WO 2016010770 A1 | 21-01-2016 |

EPO FORM P0459

For more details about this annex : see Official Journal of the European Patent Office, No. 12/82